# EUROPÄISCHE PATENTSCHRIFT

(11) **EP 0 833 207 B1**
(45) Veröffentlichungstag und Bekanntmachung des Hinweises auf die Patenterteilung: **20.11.2002**
(21) Anmeldenummer: 97116604.6
(22) Anmeldetag: 24.09.1997
(51) Int. Cl.: G03F 7/033, G03F 7/095, G03F 7/038

(54) **Flexographische Druckformen für UV härtbare Druckfarben**
Flexographic printing forms for UV-hardenable printing inks
Clichés flexographiques pour des encres d'imprimerie solidifiable par UV

(30) Priorität: 27.09.1996 DE 19639767
(43) Veröffentlichungstag der Anmeldung: 01.04.1998
(73) Patentinhaber: DU PONT DE NEMOURS (DEUTSCHLAND) GMBH, 61343 Bad Homburg v.d.H. (DE); E.I. DU PONT DE NEMOURS AND COMPANY, Wilmington Delaware 19898 (US)
(72) Erfinder: Dudek, Dietmar, Dr., 63225 Langen (DE); Hinz, Konrad, 63303 Dreieich (DE); Struck, Bernd, 63303 Dreieich (DE)

(56) Entgegenhaltungen:
- EP-A- 0 362 850
- EP-A- 0 437 068
- EP-A- 0 438 967
- WO-A-96/13238
- DE-A- 19 548 807
- US-A- 4 430 417
- US-A- 4 460 675
- US-A- 4 913 991
- US-A- 5 213 948
- US-A- 5 239 009
- PATENT ABSTRACTS OF JAPAN vol. 95, no. 2, 31. März 1995 & JP 06 306128 A (KURARAY CO., LTD.), 1. November 1994
- PATENT ABSTRACTS OF JAPAN vol. 95, no. 1, 28. Februar 1995 & JP 06 293853 A (KURARAY CO., LTD.), 21. Oktober 1994
- PATENT ABSTRACTS OF JAPAN vol. 16, no. 114 (C-0921), 23. März 1992 & JP 03 287652 A (KURARAY CO., LTD.), 18. Dezember 1991

## Beschreibung

Die Erfindung betrifft eine photopolymerisierbare Druckplatte umfassend einen Schichtträger, mindestens eine photopolymerisierbare Schicht, eine elastomere Schicht enthaltend mindestens ein thermoplastisch elastomeres Blockcopolymer und mindestens einen Photoinitiator oder ein Photoinitiatorsystem, und eine Deckschicht und eine daraus hergestellte flexographische Druckform.

Es ist bekannt, für die Herstellung von flexographischen Druckformen photopolymerisierbare Druckplatten zu verwenden, bei denen die Druckoberfläche durch bildmäßiges Belichten einer durch aktinische Strahlung photopolymerisierbaren Schicht und anschließendes Entfernen der unbelichteten, nicht photopolymerisierten Druckplattenbereiche erzeugt wird. Beispiele hierfür finden sich in den folgenden Patenten: DE-C 22 15 090, US-A 4,266,005; US-A 4,320,188; US-A 4,126,466 und US-A 4,430,417.

Solche photopolymerisierbaren Druckplatten setzen sich üblicherweise aus einem Schichtträger, ggf. einer Haft- oder anderen Unterschicht, einer oder mehreren photopolymerisierbaren Schichten, ggf. einer elastomeren Zwischenschicht und einer Deckschicht zusammen.

Eine bevorzugte Methode zur Herstellung solcher mehrschichtigen, photopolymerisierbaren Druckplatten ist ein Verfahren, bei dem in den Spalt eines Kalanders eine vorher extrudierte, photopolymerisierbare Masse eingeführt und zwischen einen Träger und ein Deckelement kalandriert wird, wodurch eine photopolymerisierbare Schicht zwischen ihnen gebildet wird. Aus der EP-B 0 084 851 ist ein Herstellungsverfahren für eine mehrschichtige, photopolymerisierbare Druckplatte bekannt, die zwischen der Deckschicht und der photopolymerisierbaren Schicht eine weitere elastomere Schicht besitzt.

Die photopolymerisierbaren Schichten enthalten polymere Bindemittel, photopolymerisierbare Monomere, Photoinitiatoren und weitere Hilfsstoffe wie Weichmacher, Füllstoffe, Stabilisatoren, u.s.w. Als polymere Bindemittel werden üblicherweise thermoplastisch elastomere Blockcopolymere verwendet, wie sie in der DE-C 22 15 090 beschrieben sind. Dies sind im allgemeinen A-B-A Blockcopolymere mit thermoplastischen Blöcken A und elastomeren Blöcken B, insbesondere lineare und radiale Blockcopolymere mit Polystyrolendblöcken wie z.B. Polystyrol-Polyisopren-Polystyrol, (Polystyrol-Polyisopren)4Si oder die entsprechenden Butadienpolymere. Für spezielle Anwendungen, wie z.B. für die Verbesserung der Eigenschaften von Druckplatten mit speziellen Monomeren (EP 0 525 206) oder zur Herstellung von Druckplatten ohne Monomerzusatz (EP-A 0 696 761), ist auch die Verwendung von Polymeren mit einem bestimmten Vinylbindungsgehalt bekannt. Ähnliche Blockcopolymere und deren Verwendung im Straßenbau und bei der Automobilherstellung sind in der EP-B 0 362 850 beschrieben. Für die Herstellung von flexographischen Druckformen werden jedoch bevorzugt Polystyrol-Polybutadien-Polystyrol- und Polystyrol-Polyisopren-Polystyrol-Blockcopolymere eingesetzt.

Häufig entsprechen jedoch die nach dem Stand der Technik hergestellten Druckformen nicht den in der Praxis im Flexodruck gestellten Anforderungen. Insbesondere bei der Verwendung von UV-härtbaren Druckfarben sind sie nicht genügend resistent gegenüber dem Eindiffundieren von Farbbestandteilen. Dies führt im Laufe des Drucks zu einer Schichtdickenzunahme, einer Veränderung der Bildgeometrie an der Druckformoberfläche und einer Abnahme der Shore A Härte. Dies wiederum äußert sich im Druckbild als unerwünschte Bildelementverbreiterung von positiven Bildelementen bzw. als Zulaufen von feinen negativen Bildelementen.

Der vorliegenden Erfindung lag daher die Aufgabe zugrunde, flexographische Druckformen mit verbesserter Resistenz gegenüber UV-härtbaren Druckfarben zur Verfügung zu stellen, die die beschriebenen Nachteile der Druckformen des Standes der Technik nicht aufweisen, ohne daß andere wesentliche Eigenschaften der photopolymerisierbaren Druckplatten oder der flexographischen Druckformen negativ beeinflußt werden.

Diese Aufgabe wurde überraschenderweise gelöst durch eine photopolymerisierbare Druckplatte umfassend einen Schichtträger, mindestens eine photopolymerisierbare Schicht, eine elastomere Schicht enthaltend mindestens ein thermoplastisch elastomeres Blockcopolymer und mindestens einen Photoinitiator oder ein Photoinitiatorsystem, und eine Deckschicht, dadurch gekennzeichnet, daß die elastomere Schicht mindestens ein thermoplastisch elastomeres Blockcopolymer zusammengesetzt aus zwei oder mehreren Polymerblöcken, aufgebaut aus aromatischen Monomeren, und einem oder mehreren Polymerblöcken, aufgebaut aus Isopren- und/oder Isopren/Butadien- Einheiten, mit einem Vinylbindungsgehalt von höchstens 70%, mit einer Glasübergangstemperatur von höchstens 20°C und mit einer Peak-Temperatur einer primären Dispersion von tan a von höchstens 30°C, enthält, und eine hieraus hergestellte flexographische Druckform.

Überraschenderweise wird durch den Einsatz der erfindungsgemäßen Polymere in der elastomeren Schicht die Beständigkeit von flexographischen Druckformen gegenüber UV-härtbaren Druckfarben wesentlich gesteigert. Desweiteren zeigen die aus den erfindungsgemäßen Materialien hergestellten Druckformen eine gute Farbübertragung.

Als erfindungswesentliche Blockcopolymere werden thermoplastisch elastomere Blockcopolymere verwendet, die zwei oder mehrere Blöcke aufgebaut aus aromatischen Monomeren und einen oder mehrere Blöcke aufgebaut aus Isopren- bzw. Isopren/Butadien-Einheiten enthalten. Bevorzugt werden Polystyrol- und Polyisopren-Blöcke verwendet.Insbesondere Polystyrol-Polyisopren-Polystyrol-Dreiblockcopolymere sind bevorzugt.

Der Vinylbindungsgehalt der erfindungsgemäßen Blockcopolymere beträgt höchstens 70%, bevorzugt 30 - 60%, und wird, wie in der EP-B 03 62 850 beschrieben, mittels NMR Spektren bestimmt. Die Glasübergangstemperatur der erfindungsgemäßen Polymere beträgt höchstens 20°C, bevorzugt -20 - +10°C. Die Peaktemperatur einer primären Dispersion von tan ∂ beträgt höchstens 30°C, bevorzugt -10 - +25°C, und wird, wie in der EP-B 0 0362 850 beschrieben, mittels visko-elastischen Bestimmungen mit einem Rheovibron® Gerät der Firma Orientec Corp. ermittelt. Der Polystyrolgehalt der erfindungswesentlichen Polymere beträgt 10 bis 30 Gew.-%, bevorzugt 15 - 25 Gew.-%. Das mittlere Molekulargewicht Mₙ dieser Polymere beträgt 30000 bis 280000, bevorzugt 60000 - 220000. Das mittlere Molekulargewicht Mₙ eines aromatischen Block beträgt 3000 bis 40000, das eines Vinylgruppen enthaltenden Elastomerblocks 10000 bis 200000.

Die erfindungswesentlichen Polymere können allein oder auch als Mischungen mit anderen thermoplastisch elastomeren Blockcopolymeren, die einen Vinylbindungsgehalt ≤ 20% aufweisen, verwendet werden. Bevorzugt werden Polymermischungen verwendet. Die Menge der erfindungswesentlichen Polymere beträgt in diesem Fall nicht weniger als 20 Gew.-%, bevorzugt 20 - 80 Gew.-%, bezogen auf die Gesamtmenge der polymeren Bindemittel. Die Gesamtmenge der Bindemittel in der elastomeren Schicht beträgt 50 - 95 Gew.-%.

Besonders geeignet als weitere Blockcopolymere sind die in der DE-C 22 15 090; der US-A 4,320,188; der US-A 4,197,130; der US-A 4,430,417 oder der US-A 4, 162,919 beschriebenen. Insbesondere lineare und radiale Blockcopolymere mit Polystyrolendblöcken wie z.B. Polystyrol-Polyisopren-Polystyrol, (Polystyrol-Polyisopren)₄Si oder die entsprechenden Butadienpolymere sind als Bindemittel geeignet, solange sie mit den erfindungswesentlichen Bindemitteln kompatibel sind. Besonders bevorzugt werden Polyisopren enthaltende Polymere verwendet. Das mittlere Molekulargewicht Mₙ der Blockcopolymere liegt üblicherweise zwischen 80 000 und 300 000, bevorzugt zwischen 100 000 und 250 000. Ein Anteil von Polystyrol von 10 - 40 Gew.-% ist vorteilhaft, vor allem ein Gehalt von 15 - 30 Gew.-%.

Üblicherweise enthält die elastomere Schicht einen Photinitiator oder ein Photoinitiatorsystem, wie z. B. Methylbenzoin, Benzoinacetat, Benzophenon, Benzil-dimethylketal, Ethylanthrachinon/4,4'-Bis-(dimethylamino)-benzophenon. Als weitere Zusätze können Farbstoffe, Füllstoffe, Weichmacher, etc.verwendet werden, wie sie in der EP-B 0 084 851 beschrieben sind.

Die Herstellung der erfindungsgemäßen elastomeren Schicht erfolgt durch Gießen aus Lösungsmitteln wie Toluol, Aceton, Methylethylketon, Alkoholen, etc oder Gemischen der genannten Lösungsmitteln oder durch Extrusionsbeschichtung direkt auf eine übliche Deckschicht wie z.B. Polystyrol, Polyethylen, Polypropylen oder Polyethylenterephthalat. Anschließend wird die Schicht getrocknet. Die Schichtdicke beträgt 0,01 bis 0,5 mm, bevorzugt 0,025 bis 0,12 mm.

Zwischen der Deckschicht und der elastomeren Schicht befindet sich ggf. eine dünne nicht klebende, mit dem Entwicklerlösungsmittel entfernbare Polymerschicht. Bevorzugt verwendet werden Polyamide, Copolymere aus Ethylen und Vinylacetat oder ähnliche Polymere, die transparente und reißfeste Filme bilden. Die Schichtdicke beträgt 0,0025 bis 0,038 mm.

Ein besonderer Vorteil der erfindungsgemäßen elastomeren Schichten ist, daß keine speziellen photopolymerisierbaren Druckplatten mit geänderter Zusammensetzung hergestellt werden müssen. Es können handelsübliche photopolymerisierbare Druckplatten verwendet werden, auf die lediglich die zusätzlichen Druckschichten aufgebracht werden müssen. Die Herstellung solcher flexographischer Druckformen für die Anwendung von UV-Farben ist somit einfacher und kostengünstiger.

Die photopolymerisierbaren Schichten der Druckplatten enhalten üblicherweise Blockcopolymere, wie sie z.B. in der DE-C 22 15 090; der US-A 4,320,188; der US-A 4,197,130; der US-A 4,430,417 oder der US-A 4, 162,919 beschriebenen. Insbesondere lineare und radiale Blockcopolymere mit Polystyrolendblöcken wie z.B. Polystyrol-Polyisopren-Polystyrol, (Polystyrol-Polyisopren)4Si oder die entsprechenden Butadienpolymere sind als Bindemittel geeignet. Das mittlere Molekulargewicht Mₙ der Blockcopolymere liegt üblicherweise zwischen 80 000 und 300 000, bevorzugt zwischen 100 000 und 250 000. Ein Anteil von Polystyrol von 10 - 40 Gew.-% ist vorteilhaft, vor allem ein Gehalt von 15 - 30 Gew.-%.

Als ethylenisch ungesättigte Verbindungen in den photopolymerisierbaren Schichten werden die bekannten einfach oder mehrfach ungesättigten Monomere wie z.B. Ester oder Amide der Acrylsäure oder Methacrylsäure mit mono- oder polyfunktionellen Alkoholen, Aminen, Aminoalkoholen oder Hydroxyethern und -estern. Geeignet sind auch Mischungen aus mono- und polyungesättigten Verbindungen wie sie in der DE-C1 37 44 243 und der DE-A 36 30 474 beschrieben werden. Als Beispiele für die additionspolymersierbaren Verbindungen seien genannt: Butylacrylat, Isodecylacrylat, Tetradecylacrylat, 2-Hexyloxyethylacrylat, 1,4-Butandioldiacrylat, 1,6-Hexandioldimethacrylat, 1,6-Hexandioldiacrylat, Trimethylolpropantriacrylat und Dipentaerythritolmonohydroxypentacrylat.

Desweiteren enthalten die photopolymerisierbaren Schichten einen der bekannten Photoinitiatoren oder ein Photoinitiatorsystem, z.B. Methylbenzoin, Benzoinacetat, Benzophenon, Benzil-dimethyl-ketal, Ethylanthrachinon/4,4'-Bis-(dimethylamino)-benzophenon.

Die photopolymerisierbare Schicht enthält allgemein 60 - 95 Gew.-% Bindemittel oder Bindemittelgemisch, 5 - 30 Gew.-% Monomer oder Monomermischung und 0,5 - 5 Gew.-% Initiator. Weitere Hilfsmittel wie z.B. Füllstoffe, Farbstoffe, Antioxidantien, Ozonschutzmittel, thermische Polymerisationsinhibitoren und Plastifizierungsmittel können in den üblichen Mengen enthalten sein.

Als Schichtträger für die erfindungsgemäßen photopolymerisierbaren Druckplatten eignen sich z.B. Folien aus den verschiedensten filmbildenden synthetischen Polymeren. Bevorzugt werden Polyester und Polyester-Polyamid-Folien, die ggf. mit einer Haftschicht und/oder einer Antihaloschicht versehen sein können, verwendet, insbesondere Polyethylenterephthaltfolien.

Die Herstellung der photopolymerisierbaren Druckplatte erfolgt nach den üblichen Verfahren. Bevorzugt wird sie durch Extrudieren und anschließendes Kalandrieren der photopolymersierbaren Masse zwischen die Trägerschicht und ein Deckelement durchgeführt. Dieses Verfahren wird in der EP-B1 0 084 851 beschrieben. Das Deckelement besteht aus einer Deckfolie, einer erfindungsgemäßen elastomeren Schicht und ggf. einer biegsamen Polymerschicht wie sie schon beschrieben wurden.

Die bildmäßige Belichtung der photopolymerisierbaren Druckplatte erfolgt nach allgemein üblichen Verfahren durch ein Negativ, wobei die Deckschicht der photopolymerisierbaren Druckplatte üblicherweise vor der bildmäßigen Belichtung entfernt wird.

Aktinische Strahlung beliebiger Herkunft und Art kann bei der Herstellung der flexographischen Druckformen benutzt werden. Geeignete Strahlungsquellen hierfür sind beispielsweise Quecksilberdampflampen, Glühlampen mit speziellen Leuchtstoffen, die Ultraviolettlicht emittieren, Argonglühlampen und Fotolampen. Am geeignetsten hiervon sind die Quecksilberdampflampen, insbesondere Ultraviolettlichtlampen und UV-Leuchtstofflampen.

Vor oder nach der bildmäßigen Belichtung kann eine vollflächige Rückseitenbelichtung durchgeführt werden. Diese Belichtung kann diffus oder gerichtet erfolgen. Als Belichtungsquellen können alle auch für die bildmäßige Belichtung üblichen Strahlungsquellen verwendet werden.

Das Auswaschen der nicht photopolymerisierten Bereiche der Druckplatte kann mit geeigneten Entwicklerlösungen, wie z. B. aliphatischen oder aromatischen Kohlenwasserstoffen wie n-Hexan, Petrolether, hydrierte Erdölfraktionen, Limonen oder anderen Terpenen oder Toluol, Isopropylbenzol, etc., Ketonen wie z.B.Methylethylketon, halogenierte Kohlenwasserstoffen wie Chloroform, Trichlorethan oder Tetrachlorethylen, Estern wie z.B. Essigsäure- oder Acetessigsäureester oder Gemischen der genannten Lösungsmittel, durchgeführt werden. Zusätze wie Tenside oder Alkohole sind möglich. Nach dem Trocknen können die so erhaltenen Druckformen zur Herstellung einer klebfreien Druckoberfläche in beliebiger Reihenfolge nachbelichtet und/oder chemisch nachbehandelt werden.

Die folgenden Beispiele sollen die vorliegende Erfindung verdeutlichen. Die angegebenen Teile und Prozente beziehen sich, falls nichts anderes angegeben ist, auf das Gewicht. Die mittleren Molekulargewichte der Polymere sind als Zahlenmittel Mₙ angegeben.

### Beispiel 1

35 µm dicke elastomere Schichten bestehend aus 96,5% eines Bindemittelgemischs aus VS-3 Polymer der Fa. Kuraray, Japan, (Vinylbindungsgehalt 37%, Glastemperatur -17°C, Peaktemperatur von tan ∂ -3 °C, Polystyrolgehalt 20%), und Cariflex 1107 der Fa. Shell (Bindemittelverhältnis gemäß Tabelle 1), 3% Irgacure 651 und 0,5% eines handelsüblichen blauen Farbstoffs wurden durch Vergießen von 25%igen Lösungen (Toluol/Isopropanol, 9:1) an einem Schlitzgießer und anschließendes Trocknen hergestellt. Diese Schichten wurden dann auf die Photopolymerschichten üblicher Flexodruckplatten Cyrel® UVP der Firma DuPont unter Hitze und Druck aufgebracht. Diese Platten wurden anschließend in der für photopolymere Flexodruckplatten üblichen Weise verarbeitet (dh. belichtet, ausgewaschen und nachbelichtet). Aus Vollflächenbereichen wurden 3x3 cm große Stücke geschnitten und deren Gewicht und Schichtdicke bestimmt. Dann wurden die Proben für 24 Stunden mit UV-Farbe (Magenta der Fa. Hartmann) überschichtet, gesäubert und erneut vermessen. Die prozentuale Gewichtszunahme und die Schichtdickenzunahme der jeweiligen Proben sind in der Tabelle 1 aufgeführt.

**Tabelle 1**

| Material | | | %Gew.-Zunahme | Dickenzunahme (µm) |
|---|---|---|---|---|
| 1. | ohne elastomere Schicht | | 1,78 | 27 |
| 2. | mit elastomerer Schicht | | | |

| Verhältnis der Bindemittel | | | | |
|---|---|---|---|---|
| | vs-3 | 1107 | | |
| a) | 3,5 | 1 | 1,23 | 4 |
| b) | 2 | 1 | 1,28 | 15 |
| c) | 1,6 | 1 | 1,32 | 15 |

## Patentansprüche

1. Photopolymerisierbare Druckplatte umfassend einen Schichtträger, mindestens eine photopolymerisierbare Schicht, eine elastomere Schicht enthaltend mindestens ein thermoplastisch elastomeres Blockcopolymer und mindestens einen Photoinitiator oder ein Photoinitiatorsystem, und eine Deckschicht,
**dadurch gekennzeichnet, daß**
die elastomere Schicht mindestens ein thermoplastisch elastomeres Blockcopolymer zusammengesetzt aus zwei oder mehreren Polymerblöcken, bestehend aus aromatischen Vinyleinheiten, und einem oder mehreren Polymerblöcken, bestehend aus Isopren- und/oder Isopren/Butadien-Einheiten, mit einem Vinylbindungsgehalt von höchstens 70%, mit einer Glasübergangstemperatur von höchstens 20°C und mit einer Peak-Temperatur einer primären Dispersion von tan ∂ von höchstens 30°C, enthält.

2. Photopolymerisierbare Druckplatte gemäß Anspruch 1,
**dadurch gekennzeichnet, daß**
der Vinylbindungsgehalt des thermoplastisch elastomeren Blockcopolymers 30-60 % beträgt.

3. Photopolymerisierbare Druckplatte gemäß Anspruch 1-2,
**dadurch gekennzeichnet, daß**
das thermoplastisch elastomere Blockcopolymer ein Polystyrol-Polyisopren-Polystyrol-Dreiblockcopolymer ist.

4. Photopolymerisierbare Druckplatte gemäß Anspruch 1-3,
**dadurch gekennzeichnet, daß**
der Polystyrolgehalt des thermoplastisch elastomeren Blockcopolymeren 10-30 Gew.-% beträgt.

5. Photopolymerisierbare Druckplatte gemäß Anspruch 1-4,
**dadurch gekennzeichnet, daß**
die Glasübergangstemperatur des thermoplastisch elastomeren Blockcopolymers höchstens 0°C beträgt.

6. Photopolymerisierbare Druckplatte gemäß Anspruch 1-5,
**dadurch gekennzeichnet, daß**
als weiteres Bindemittel ein Polystyrol-Polyisopren-Polystyrol Blockcopolymer mit einem Vinylbindungsgehalt ≤ 20% verwendet wird.

7. Photopolymerisierbare Druckplatte gemäß Anspruch 1-6,
**dadurch gekennzeichnet, daß**
die Menge des thermoplastisch elastomeren Blockcopolymeren gemäß Anspruch 1-5 20 - 80 Gew.-% bezogen auf die Gesamtmenge der polymeren Bindemittel beträgt.

8. Photopolymerisierbare Druckplatte gemäß Anspruch 1-7,
**dadurch gekennzeichnet, daß**
zwischen der elastomeren Schicht und der Deckschicht eine weitere polymere Schutzschicht vorhanden ist.

9. Flexographische Druckform herstellbar aus einer photopolymerisierbaren Druckplatte gemäß einem der Ansprüche 1-8.

## Claims

1. Photopolymerizable printing plate comprising a support, at least one photopolymerizable layer, an elastomeric layer containing at least one elastomeric binder, and at least one photoinitiator or a photoinitiator system, and a cover sheet
**characterized in that**
the elastomeric layer contains at least one thermoplastic, elastomeric, block copolymer, composed of two or more polymer blocks comprising aromatic vinyl units and one or more polymer blocks comprising isoprene and/or isoprene/butadiene units, having a vinyl bond content not above 70 %, a glass transition temperature not above 20 °C, and a peak temperature of a primary dispersion of tan δ not above 30 °C.

2. Photopolymerizable printing plate according to claim 1
**characterized in that**,
the vinyl bond content of the thermoplastic, elastomeric, block copolymer is between 30 to 60 %.

3. Photopolymerizable printing plate according to claim 1 to 2
**characterized in that**,
the thermoplastic, elastomeric, block copolymer is a polystyrene-polyisoprene-polystyrene triple-block copolymer.

4. Photopolymerizable printing plate according to claim 1 to 3
**characterized in that**,
the polystyrene content of the thermoplastic, elastomeric, block copolymer is 10 - 30 % by weight.

5. Photopolymerizable printing plate to claim 1 to 4
**characterized in that**,
the glass transition temperature of the thermoplastic, elastomeric, block copolymer is not above 0 °C.

6. Photopolymerizable printing plate according to claim 1 to 5
**characterized in that**,
a polystyrene-polyisoprene-polystyrene block copolymer having a vinyl bond content ≤ 20 % is used as additional binder.

7. Photopolymerizable printing plate according to claim 1 to 6
**characterized in that**,
the quantity of the thermoplastic, elastomeric, block copolymer according to claims 1- 5 is 20 - 80 % by weight, relative to the total weight of the elastomeric binders.

8. Photopolymerizable printing plate according to claim 1 to 7
**characterized in that**,
an additional polymeric protective layer exists between the elastomeric layer and the cover sheet.

9. Flexographic printing form that can be prepared from a photopolymerizable printing plate according to claim 1 to 8.

## Revendications

1. Plaque d'impression photopolymérisable, comprenant un support de couche, au moins une couche photopolymérisable, une couche élastomère contenant au moins un copolymère bloc élastomère thermoplastique et au moins un photo-amorceur ou un système photo-amorceur, et une couche de couverture,
**caractérisée en ce que** la couche élastomère contient au moins un copolymère bloc élastomère thermoplastique composé de deux ou de plusieurs blocs polymères, constitués par des unités de vinyle aromatiques, et d'un ou de plusieurs blocs polymères, constitués par des unités d'isoprène et/ou d'isoprène/butadiène, avec une teneur en liants vinyliques maximale de 70%, une température de transition vitreuse maximale de 20°C et une température de pointe d'une dispersion primaire de tan δ maximale de 30°C.

2. Plaque d'impression photopolymérisable selon la revendication 1, **caractérisée en ce que** la teneur en liants vinyliques du copolymère bloc élastomère thermoplastique représente 30% à 60%.

3. Plaque d'impression photopolymérisable selon les revendications 1 et 2, **caractérisée en ce que** le copolymère bloc élastomère thermoplastique est un copolymère à trois blocs polystyrène-polyisoprène-polystyrène.

4. Plaque d'impression photopolymérisable selon les revendications 1 à 3, **caractérisée en ce que** la teneur en polystyrène du copolymère bloc élastomère thermoplastique représente 10 à 30% en poids.

5. Plaque d'impression photopolymérisable selon les revendications 1 à 4 **caractérisée en ce que** la température de transition vitreuse maximale du copolymère thermoplastique élastomère est de 0°C.

6. Plaque d'impression photopolymérisable selon les revendications 1 à 5 **caractérisée en ce qu'**un copolymère bloc polystyrène-polyisoprène-polystyrène avec une teneur en liants vinyliques ≤ 20% est utilisé comme liant supplémentaire.

7. Plaque d'impression photopolymérisable selon les revendications 1 à 6 **caractérisée en ce que** la quantité du copolymère bloc élastomère thermoplastique selon les revendications 1 à 5 représente 20 à 80% en poids par rapport à la quantité totale des liants polymères.

8. Plaque d'impression photopolymérisable selon la revendication 1 à 7, **caractérisée en ce qu'**une couche de protection polymère supplémentaire est agencée entre la couche élastomère et la couche de couverture.

9. Cliché flexographique pouvant être produit à partir d'une plaque d'impression photopolymérisable selon l'une des revendications 1 à 8.
